# EUROPÄISCHE PATENTSCHRIFT

(11) **EP 1 776 230 B1**
(45) Veröffentlichungstag und Bekanntmachung des Hinweises auf die Patenterteilung: **01.12.2010**
(21) Anmeldenummer: 05770014.8
(22) Anmeldetag: 13.07.2005
(51) Int. Cl.: B32B 27/40, B32B 7/02, C09K 5/06, G11C 11/00

(54) **MEHRLAGIGE WÄRMELEITFOLIE**
THERMALLY CONDUCTING MULTI-LAYER FILM
FILM THERMOCONDUCTEUR MULTICOUCHE

(30) Priorität: 13.08.2004 DE 102004039565
(43) Veröffentlichungstag der Anmeldung: 25.04.2007
(73) Patentinhaber: Kerafol Keramische Folien GmbH, 92676 Eschenbach/Opf. (DE)
(72) Erfinder: KOPPE, Franz, 92676 Eschenbach/Opf. (DE); HAAS, Werner, 91257 Pegnitz (DE)
(74) Vertreter: Hafner, Dieter
(86) Internationale Anmeldenummer: PCT/DE2005/001234
(87) Internationale Veröffentlichungsnummer: WO 2006/015569

(56) Entgegenhaltungen:
- WO-A-02/059965
- WO-A-2004/090944
- WO-A-2005/038913
- US-A1- 2004 009 353

## Beschreibung

Die Erfindung betrifft eine mehrlagige Wärmeleitfolie, die aus einer ersten Lage besteht, welche durch eine elektrisch isolierende, wärmeleitende verfüllte, hochelastische Elastomerschicht gebildet wird Diese Schicht ist in der Lage, sich in Folge ihrer Gel-Charakteristik dauerhaft an eine unebene Oberflächenstruktur einer elektronischen Schaltung anzuformen. Darüber hinaus weist die Wärmeleitfolie mindestens eine zweite Lage auf, die wesentlich dünner als die erste Lage ist und mit dieser fest verbunden ist.

Eine bekannte mehrlagige Wärmeleitfolien werden in der Regel dazu verwendet, aus unebenen Strukturen, die thermisch empfindliche elektronische Bauelemente enthalten oder aus diesen bestehen, Hitze abzuleiten. Derartige Folien sind mit einer Dicke von 0,5 - 5 mm erhältlich, weisen einen thermischen Widerstand zwischen 0,25 - 1,75 K7W auf und gewährleisten eine Wärmeleitfähigkeit im Bereich zwischen 0,8 - 5 W/mK. Der thermische Verwendungsbereich derartige Wärmeleitfolien, die auch als Gap-Filler-Folien bezeichnet werden, liegt im Bereich von - 60 - +200 °C, Derartige Gap-Filler-Materialien sind beispielsweise in der Produktübersicht der Firma Kerafol Keramische Folien GmbH, Eschenbach beschrieben und werden dort als Produkt "Soft-therm" bezeichnet.

Nachteilig an derartigen bekannten Wärmeleitfolien ist eine Trägerschicht, die in der Regel eine Dicke von etwa 0,1 cm aufweist. Diese Trägerschicht hat einen relativ hohen Wärmewiderstandswert, so daß die Wärmeeinleitung in ein darauf aufgebrachtes Gehäuseelement einen Kühlkörper oder dergleichen begrenzt ist.

US 2004/0009353 A1 lehrt eine ein Wachs enthaltende PCM-Schicht (phase change material), welche die Wärme über eine Karbonfaserschicht abführt. Diese PCM-Schicht wird auf eine flache Basis, Membrane oder Spitzenbereiche eines Faserstoffes befestigt. Ferner umfaßt die PCM-Schicht Wachs, wärmeleitende Festpartikel und/oder Nanofasern.

WO 02/059965 A1 lehrt ein rückstandsfrei ablösbares thermisches Verbindungsstück mit Phasenübergangsmaterial. Dieses Material wird als Schnittstelle für den Wärmeaustausch beispielsweise zwischen passenden wkmeauswnschflächen eines wärmeerzeugenden elektronischen Bauteils wie eines Chips mit integrierter Schaltung und einem Wärmeableitungselement wie einem Kühlkörpers oder einem Verteiler für die Leitungsküblung des elektronischen Bauteils verwendet. Hierfür wird eine graphithaltige PCM-Schicht auf einer Folie verwendet. Diese PCM-Schicht enthält weder ein Bindemittel, noch besitzt diese gelcbarakterisierende Eigenschaften.

Der Erfindung/Neuerung liegt die Aufgabe zugrunde, eine mehrlagige Wärmeleitfolie mit den Merkmalen des Oberbegriffes des Anspruches 1 derart weiter zu bilden, daß eine bessere Ableitung aus der hochelastischen Elastomerschicht mit Gel-Charakteristik sichergestellt ist. Diese Aufgabe wird erfindungsgemäß dadurch gelöst, daß die zweite Lage als auf die erste Lage aufgebrachte PCM-Schicht ausgebildet ist, die sich beim Aufbringen eines Kühlkörpers oder Gehäuseelementes durch Druck- und/oder Temperatureinfluß ausdünnt und/oder eine Änderung ihres Aggregatszustandes bewirkt.

Im Prinzip sind derartige PCM-Schichten für sich bekannt, neu und vorteilhaft zur Lösung der Aufgabe hat sich aber die Kombination der beiden beschriebenen Schichten erwiesen, wobei die den Wärmewiderstand erhöhende Trägerschicht weggelassen wird und die PCM-Schicht unmittelbar auf die Elastomerschicht aufgebracht wird. Tests haben ergeben, daß der Wärmewiderstandswert um einen Faktor 2 - 10 verbessert ist, wenn die zweite Schicht nicht als Trägerschicht, sondern als PCM-Schicht ausgebildet ist.

Weiterbildungen der Erfindung ergeben sich aus den Unteransprüchen 2 - 20. So kann die erste Schicht beispielsweise Silikon enthalten oder aus einem silikonfreien elastomeren aliphatischen Polyurethan bestehen, wobei das Polyurethan frei von ungebundenen Isozyanat-Gruppen sein kann. Es ist auch möglich, die erste Schicht aus Polydimethylsiloxan bestehen zu lassen, wobei das Polyurethan oder das Polydimethylsiloxan mit pulverartigen Füllstoffen mit 50 - 95 % verfüllt ist. Die Verfüllung kann aus Aluminiumoxidteilchen, Siliziumoxidteilchen, Berilliumoxidteilchen, Magnesiumoxidteilchen, Aluminiumnitridteilchen, Bohrnitridteilchen, Siliziumnitridteilchen, Siliziumkarbidteilchen oder Metallteilchen bestehen.

Zur Stabilisierung kann die erste Lage mit einem Gehalt von 0,5 - 15 % eines Melaminharzes versetzt sein. Die Shore-Härte der ersten Lage beträgt 5 - 80, als vorteilhafter Dickenbereich haben sich 0,3 - 6 mm erwiesen.

Die zweite Lage soll aus einer wachsartigen Substanz bestehen oder zumindest eine solche enthalten. Es ist aber auch möglich, ein Kopolymer als zweite Lage vorzusehen.

Die zweite Lage kann auch aus einem thermoplastischen Silikonpolymer bestehen oder ein solches enthalten. Im Temperaturbereich von 40°C - 140°C ist ein fest/flüssiger-Phasenübergang der die zweite Lage bildenden PCM-Schicht vorgesehen. Das Material der zweiten Lage kann ebenfalls mit thermisch leitenden Materialien verfüllt sein. Das Material der ersten und/oder zweiten Lage kann mit einer z. B. aus Metallen oder Kunststoffen, Glasfasern, Carbon oder Graphit bestehenden Verstärkung versehen sein. Die Verstärkung der ersten oder zweiten Lage kann auch gewebeartig ausgebildet sein. Schließlich ist es vorteilhaft, die freien Oberflächen der ersten und/oder zweiten Lage mit einer Klebeschicht zu versehen. Zur Lagerhaltung ist es ferner vorteilhaft, auf den freien Oberflächen der ersten und/oder zweiten Lage eine abziehbare Schutzschicht anzubringen.

Die Erfindung ist anhand eines vorteilhaften Ausführungsbeispieles in den Zeichnungsfiguren näher erläutert. Diese zeigen
- Fig. 1: eine mehrlagige Wärmeleitfolie nach dem Stand der Technik, wobei die zweite Lage als dünne Trägerschicht ausgebildet ist,
- Fig. 2: eine mehrlagige Wärmeleitfolie nach der Erfindung,
- Fig.3 3: einen Schnitt durch eine mit elektronischen Bauelementen versehene Leiterplatte, auf der die erfindungsgemäße mehrlagige Wärmeleitfolie aufgebracht ist, die auf der der Leiterplatte gegenüberliegenden Seite an ein Gehäuseelement oder eine Kühlkörperoberfläche angrenzt.

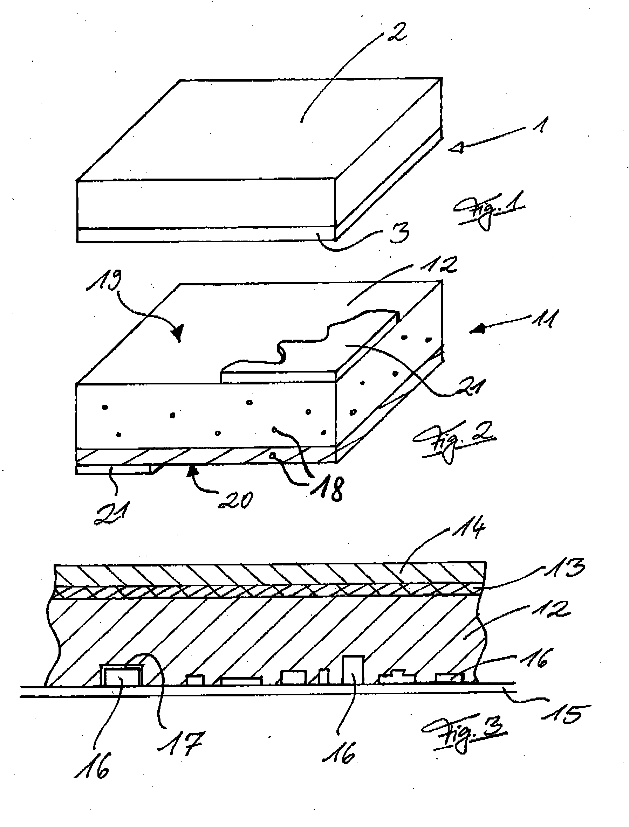

Die in Fig. 1 dargestellte mehrlagige Wärmeleitfolie 1 nach dem Stand der Technik besteht im wesentlichen aus einer ersten Lage 2 und einer unmittelbar daran angrenzende, auf die erste Lage 2 aufgebrachte zweite Lage 3, wobei die zweite Lage wesentlich dünner als die erste Lage 1 ist. Zwischen den beiden Lagen 2 und 3 besteht eine feste Verbindung.

Bei der aus dem Stand der Technik bekannten Wärmeleitfolie 1, schematisch dargestellt ist, besteht die erste Lage 2 aus einer elektrisch isolierenden wärmeleitenden, verfüllen, hochelastischen Elastomerschicht mit Gel-Charakteristik, die zweite Lage ist eine Trägerschicht, die in der Regel dazu dient, die erste Lage 2 zu stabilisieren.

Bei der erfindungsgemäßen Wärmeleitfolie 11, ist die erste Lage 12 entsprechend der ersten Lage 2 der in Fig. 1 dargestellten Wärmeleitfolie ausgebildet, allerdings ist die Trägerschicht 3 nicht mehr vorhanden, sondern an eine Oberfläche der ersten Lage 12 grenzt unmittelbar eine zweite Lage an, die sich beim Aufbringen eines Kühlkörpers oder Gehäuseelementes 14 (Fig. 3) ausdünnt und/oder durch Druck- und/oder Temperatureinfluß eine Änderung ihres Aggregatszustandes bewirkt. Dadurch kommt es zu einem sehr intensiven Wärmekontakt zwischen der ersten Schicht und dem Gehäuseelement 14. In Fig. 3 ist schematisch noch eine Leiterplatte 15 dargestellt, auf der elektronische Bauelemente 16 angebracht sind, die von Eindellungen oder Eindrückungen 17 der ersten Lage 12 mehr oder weniger dicht umschlossen sind, so daß eine gute Wärmeableitung aus den Bauelementen 16 in die erste Lage 12 der ' Wärmeleitfolie 11 sichergestellt ist.

Es ist möglich, das Material der ersten Lage 12 oder der zweiten Lage 13 mit Verstärkungsteilchen 18 zu versehen oder eine gewebeartige Verstärkung einzubringen, die im einzelnen nicht dargestellt ist.

Die freien Oberflächen 19 und/oder 20 der ersten und/oder der zweiten Lage 12, 13 können mit einer abziehbaren Schutzschicht 21 versehen sein, die in Zeichnungsfigur nur bereichsweise angedeutet ist.

## Patentansprüche

1. Mehrlagige Wärmeleitfolie (1), bestehend aus einer ersten Lage (12), die durch eine elektrisch isolierende wärmeleitende, verfüllte, hochelastische Elastomerschicht gebildet ist, die in Folge ihrer Gel-Charakteristik dauerhaft an die unebene Oberflächenstruktur einer elektronischen Schaltung anformbar ist, sowie mindestens einer zweiten Lage (13), die wesentlich dünner als die erste Lage (12) und mit dieser fest verbunden ist,
**dadurch gekennzeichnet, dass**
die zweite Lage (13) als auf die erste Lage (12) aufgebrachte PCM-Schicht ausgebildet ist, die sich beim Aufbringen eines Kühlkörpers (14) oder Gehäuseeletaaentes durch Druck- und/oder Temperatureinfluss ausdünnt und/oder eine Änderung ihres Aggregatzustandes bewirkt.

2. Wärmeleitfolie nach Anspruch 1,
**dadurch gekennzeichnet, daß**
die erste Lage (12) Silikon enthält.

3. Wärmeleitfolie nach Anspruch 1,
**dadurch gekennzeichnet, daß**
die erste Lage (12) aus einem silikonfreien elastomeren aliphatischen Polyurethan besteht.

4. Wärmeleitfolie nach Anspruch 3,
**dadurch gekennzeichnet, daß**
das Polyurethan frei von ungebundenen Isozyanatgruppen ist.

5. Wännelei#olie nach einem der vorhergehenden Ansprüchen,
**dadurch gekennzeichnet, daß**
die erste Lage (12) aus Polydimethylsiloxan besteht.

6. Wärmeleitfolie nach einem der vorhergehenden Ansprüche,
**dadurch gekennzeichnet, daß**
das Polyurethan oder Polydimethylsiloxan mit pulverartigen Füllstoffen mit 50 - 95 % verfüllt ist.

7. Wärmeleitfolie nach einem der vorhergehenden Ansprüchen,
**dadurch gekennzeichnet, daß**
die Verfüllung aus Aluminiumoxid-, Siliziumoxid-, Berilliumoxid-, Magnesiumoxid-, Aluminiumnitrid-, Bohrnitrid-, Siliziumnitrid-, Metall- und/oder Siliziumkarbidteilchen besteht.

8. Wärmeleitfolie nach einem der vorhergehenden Ansprüchen,
**dadurch gekennzeichnet, daß**
die erste Lage (12) mit einem Gehalt von 0,5 - 15 % eines Melaminharzes versetzt ist.

9. Wärmeleitfolie nach einem der vorhergehenden Ansprüchen,
**dadurch gekennzeichnet, daß**
die Shorehärte der ersten Lage 5 - 80 beträgt.

10. Wärmeletfolie nach einem der vorhergehenden Ansprüche,
**dadurch gekennzeichnet, daß**
die Dicke der ersten Lage (12) 0,3 - 6 mm beträgt.

11. Wärmeleitfolie nach einem der vorhergehenden Ansprüche,
**dadurch gekennzeichnet, daß**
die zweite Lage (13) aus einer wachsartigen Substanz besteht oder eine solche enthält.

12. Wärmeleitfolie nach einem der vorhergehenden Ansprüche,
**dadurch gekennzeichnet, daß**
die zweite Lage (13) aus einem Copolymer besteht oder ein solches enthält.

13. Wärmeleitfolie nach einem der Ansprüche 1 - 11,
**dadurch gekennzeichnet, daß**
die zweite Lage (13) aus einem thermoplastischen Silikonpolymer besteht oder ein solches enthält.

14. Wärmeleitfolie nach einem der vorhergehenden Ansprüche,
**dadurch gekennzeichnet, daß**
die die zweite Lage (13) bildende PCM-Schicht im Temperaturintervall von 40 °C-140 °C einen Fest-Flüssig-Phasenübergang zeigt.

15. Wärmeleitfolie nach einem der vorhergehenden Ansprüche,
**dadurch gekennzeichnet, daß**
das Material der zweiten Lage (13) mit thermisch leitenden Materialien verfüllt ist.

16. Wärmeleitfolie nach einem der vorhergehenden Anspruch,
**dadurch gekennzeichnet, daß**
das Material der ersten (12) und/oder zweiten Lage (13) mit einer Verstärkung (18) versehen ist.

17. Wärmeleitfolie nach Anspruch 16,
**dadurch gekennzeichnet, daß**
die Verstärkung aus metallischen Materialien oder Kunststoffen, Glasfasern, Karbon oder Graphit besteht.

18. Wärmeleitfolie nach einem der vorhergehenden Ansprüche,
**dadurch gekennzeichnet, daß**
die erste (12) und/oder die zweite Lage (13) mit einer gewebeartigen Verstärkung versehen ist.

19. Wärmeleitfolie nach einem der vorhergehenden Ansprüche,
**dadurch gekennzeichnet, daß**
die freien Oberflächen (19, 20) der ersten (12) und/oder zweiten Lage (13) mit einer Klebeschicht versehen sind.

20. Wärmeleitfolie nach einem der vorhergehenden Ansprüche,
**dadurch gekennzeichnet, daß**
die freien Oberflächen (19, 20) der ersten (12) und/oder zweiten Lage (13) mit einer abziehbaren Schutzschicht (21) versehen sind.

## Claims

1. A thermally conducting multi-layer film (1) which consists of a first layer (12) configured by an electrically insulating, thermally conducting, filled in, highly elastic elastomer layer which due to its gel characteristics can be permanently molded onto the uneven surface structure of an electronic circuit, and at least one second layer (13) which is considerably thinner than the first layer (12) and firmly linked therewith,
**characterized in that**
the second layer (13) is configured as a PCM layer which is applied to the first layer (12) and thins out and/or brings about a change of its aggregate state under the influence of pressure and/or temperature when a cooling body (14) or housing element is applied.

2. The thermally conducting film according to claim 1,
**characterized in that**
the first layer (12) contains silicon.

3. The thermally conducting film according to claim 1,
**characterized in that**
the first layer (12) consists of a silicon-free elastomer aliphatic polyurethane.

4. The thermally conducting film according to claim 3,
**characterized in that**
the polyurethane is free of uncombined isocyanate groups.

5. The thermally conducting film according to one of the preceding claims,
**characterized in that**
the first layer (12) consists of polydimethylsiloxane.

6. The thermally conducting film according to one of the preceding claims,
**characterized in that**
the polyurethane or polydimethylsiloxane is filled with 50 - 95 % powdery filler.

7. The thermally conducting film according to one of the preceding claims,
**characterized in that**
the filling consists of aluminium oxide-, silicon oxide-, beryllium oxide-, magnesium oxide-, aluminium nitride-, boron nitride-, silicon nitride-, metal- and/or silicon carbide-particles.

8. The thermally conducting film according to one of the preceding claims,
**characterized in that**
the first layer (12) is mixed with a content of 0.5 -15 % of a melamine resin.

9. The thermally conducting film according to one of the preceding claims,
**characterized in that**
the shore hardness of the first layer is 5 - 80.

10. The thermally conducting film according to one of the preceding claims,
**characterized in that**
the thickness of the first layer (12) is 0.3 - 6 mm.

11. The thermally conducting film according to one of the preceding claims,
**characterized in that**
the second layer (13) consists of or includes a waxy substance.

12. The thermally conducting film according to one of the preceding claims,
**characterized in that**
the second layer (13) consists of or includes a copolymer.

13. The thermally conducting film according to claims 1 to 11,
**characterized in that**
the second layer (13) consists of or includes a thermoplastic silicone polymer.

14. The thermally conducting film according to one of the preceding claims,
**characterized in that**
the PCM layer forming the second layer (13) has a solid-liquid-transition in the temperature range between 40°C and 140°C.

15. The thermally conducting film according to one of the preceding claims,
**characterized in that**
the material of the second layer (13) is filled with thermally conductive material.

16. The thermally conducting film according to one of the preceding claims,
**characterized in that**
the material of the first (12) and/or the second layer (13) is provided with a support (18).

17. The thermally conducting film according to claim 16,
**characterized in that**
the support is made of metal material or plastic, glass fiber, carbon or graphite.

18. The thermally conducting film according to one of the preceding claims,
**characterized in that**
the first (12) and/or the second layer (13) is provided with a weblike support.

19. The thermally conducting film according to one of the preceding claims,
**characterized in that**
the free surfaces (19, 20) of the first (12) and/or second layer (13) are provided with an adhesive layer.

20. The thermally conducting film according to one of the preceding claims,
**characterized in that**
the free surfaces (19, 20) of the first (12) and/or second layer (13) are provided with a removable protective layer (21).

## Revendications

1. Film thermoconducteur multicouche (1), composé d'une première couche (12) qui est formée d'une couche d'élastomère hautement élastique remplie, thermoconductrice, électriquement isolante, qui par suite de sa caractéristique de gel, peut être moulée de façon permanente sur la structure de surface inégale d'un circuit électronique, ainsi que d'au moins une deuxième couche (13) qui est sensiblement plus mince que la première couche (12) et fermement liée à celle-ci,
**caractérisé en ce que**
la deuxième couche (13) est réalisée sous la forme d'une couche de PCM appliquée sur la première couche (12) qui s'amincit et/ou provoque un changement de son état physique sous l'influence de la pression et/ou de la température lors de l'application d'un dissipateur de chaleur (14) ou d'un élément de boîtier.

2. Film thermoconducteur selon la revendication 1,
**caractérisé en ce que**
la première couche (12) contient de la silicone.

3. Film thermoconducteur selon la revendication 1,
**caractérisé en ce que**
la première couche (12) est composée d'un polyuréthane aliphatique élastomère sans silicone.

4. Film thermoconducteur selon la revendication 3,
**caractérisé en ce que**
le polyuréthane est dépourvu de groupes isocyanates non fixés.

5. Film thermoconducteur selon une des revendications précédentes,
**caractérisé en ce que**
la première couche (12) est composée de polydiméthylsiloxane.

6. Film thermoconducteur selon une des revendications précédentes,
**caractérisé en ce que**
le polyuréthane ou le polydiméthylsiloxane est rempli à 50 - 95 % de matières de remplissage pulvérulentes.

7. Film thermoconducteur selon une des revendications précédentes,
**caractérisé en ce que**
le remplissage est composé de particules d'oxyde d'aluminium, d'oxyde de silicium, d'oxyde de béryllium, d'oxyde de magnésium, de nitrure d'aluminium, de nitrure de bore, de nitrure de silicium, de métal et/ou de carbure de silicium.

8. Film thermoconducteur selon une des revendications précédentes,
**caractérisé en ce que**
la première couche (12) présente une teneur de 0,5 - 15 % d'une résine de mélamine.

9. Film thermoconducteur selon une des revendications précédentes,
**caractérisé en ce que**
la dureté Shore de la première couche est comprise entre 5 et 80.

10. Film thermoconducteur selon une des revendications précédentes,
**caractérisé en ce que**
l'épaisseur de la première couche (12) est comprise entre 0,3 et 6 mm.

11. Film thermoconducteur selon une des revendications précédentes,
**caractérisé en ce que**
la deuxième couche (13) est composée d'une substance cireuse ou contient une substance cireuse.

12. Film thermoconducteur selon une des revendications précédentes,
**caractérisé en ce que**
la deuxième couche (13) est composé d'un copolymère ou contient un copolymère.

13. Film thermoconducteur selon une des revendications 1 à 11,
**caractérisé en ce que**
la deuxième couche (13) est composée d'un polymère de silicone thermoplastique ou contient un polymère de silicone thermoplastique.

14. Film thermoconducteur selon une des revendications précédentes,
**caractérisé en ce que**
la couche de PCM formant la deuxième couche (13) subit une transition de phase solide-liquide dans l'intervalle de température de 40 °C à 140°C.

15. Film thermoconducteur selon une des revendications précédentes,
**caractérisé en ce que**
le matériau de la deuxième couche (13) est rempli de matériaux thermoconducteurs.

16. Film thermoconducteur selon une des revendications précédentes,
**caractérisé en ce que**
le matériau de la première (12) et/ou de la deuxième couche (13) est doté d'un renfort (18).

17. Film thermoconducteur selon la revendication 16,
**caractérisé en ce que**
le renfort est composé de matériaux métalliques ou de matières plastiques, de fibres de verre, de carbone ou de graphite.

18. Film thermoconducteur selon une des revendications précédentes,
**caractérisé en ce que**
la première (12) et/ou la deuxième couche (13) est dotée d'un renfort à la manière d'un tissu.

19. Film thermoconducteur selon une des revendications précédentes,
**caractérisé en ce que**
les surfaces libres (19, 20) de la première (12) et/ou de la deuxième couche (13) sont dotées d'une couche adhésive.

20. Film thermoconducteur selon une des revendications précédentes,
**caractérisé en ce que**
les surfaces libres (19, 20) de la première (12) et/ou de la deuxième couche (13) sont dotées d'une couche protectrice décollable (21).
